# EUROPEAN PATENT APPLICATION

(11) **EP 4 726 782 A1**
(43) Date of publication of application: **15.04.2026**
(21) Application number: 24819037.3
(22) Date of filing: 18.04.2024
(51) Int. Cl.: H01L 29/786, H01L 21/336

(54) **TRANSISTOR, METHOD FOR MANUFACTURING SAME, AND INTEGRATED CIRCUIT**

(30) Priority: 09.06.2023 JP 2023095711
(71) Applicant: Tohoku University, Sendai-shi, Miyagi 980-8577 (JP); National Institute of Information and Communications Technology, Koganei-shi, Tokyo 184-8795 (JP); SHIN-ETSU CHEMICAL CO., LTD., Tokyo 100-0005 (JP)
(72) Inventor: FUKIDOME Hirokazu, Sendai-shi, Miyagi 980-8577 (JP); WATANABE Issei, Koganei-shi, Tokyo 184-8795 (JP); KAWAHARA Minoru, Tokyo 100-0005 (JP); AKIYAMA Shoji, Annaka-shi, Gunma 379-0195 (JP); TOBISAKA Yuji, Annaka-shi, Gunma 379-0195 (JP); KAWAI Makoto, Annaka-shi, Gunma 379-0195 (JP)
(74) Representative: Vossius & Partner Patentanwälte Rechtsanwälte mbB
(86) International application number: PCT/JP2024/015405
(87) International publication number: WO 2024/252799

(57) **Abstract**

A transistor with an extremely short gate length and an extremely thin carrier transport layer is provided.

The transistor comprises a substrate that includes a flat uppermost plane, a vertical plane that intersects the uppermost plane and extends downwardly from the uppermost plane, and a lower plane substantially parallel to the uppermost plane and intersecting the vertical plane; a conductive thin film formed in contact with the uppermost plane of the substrate; an insulating film formed to cover at least the vertical plane and edges of the conductive thin film; a two-dimensional semiconductor layer formed to cover the uppermost plane, the vertical plane, and the lower plane, the two-dimensional semiconductor layer being also formed to cover the conductive thin film and/or insulating film at a portion where the conductive thin film and/or insulating film exist; a source electrode provided at a portion where the uppermost plane is covered by the two-dimensional semiconductor layer; and a drain electrode provided at a portion where the lower plane is covered by the two-dimensional semiconductor layer.

## Description

### TECHNICAL FIELD

The present invention relates to transistors with extremely short gate lengths and extremely thin carrier transport layers, manufacturing methods therefor, and integrated circuits.

### BACKGROUND ART

In order to realize the next-generation mobile communication systems (so-called 6G and Beyond 5G), further speed enhancement of analog front-end amplifiers and logic integrated circuits, which form the core of the baseband, is required. To achieve this enhanced speed, extremely short gate lengths and extremely thin carrier transport layers (channels) are necessary. As for the extremely short gate length, technology capable of reducing the gate length down to the single-atom level is required. Similarly, for carrier transport layer thinning, technology capable of achieving single-atom-level thickness is also required.

In conventional semiconductor integrated circuit manufacturing, lithography using ultraviolet light has been employed. For future semiconductor integrated circuit manufacturing, technological development is progressing along the same lines as conventional technology, aiming to achieve extreme miniaturization by using so-called extreme ultraviolet (EUV) light with even shorter wavelengths than ultraviolet. However, semiconductor manufacturing equipment using EUV is becoming increasingly large and expensive, and it also uses hazardous substances. Consequently, progress in EUV technology is anticipated to become difficult in the near future.

In such circumstances, a transistor featuring a single-atom-thick gate and a channel made of MoS₂ single-atom-layer, which is a two-dimensional semiconductor, have been proposed to meet the demands for extremely short gate lengths and extremely thin carrier transport layers (see, for example, Non-Patent Document 1).

### PRIOR ART DOCUMENTS

### NON-PATENT DOCUMENTS

[Non-Patent Document 1] Fan Wu et al. Nature 603 (2022) 259

### SUMMARY OF THE INVENTION

### PROBLEMS TO BE SOLVED BY THE INVENTION

The transistor described in Non-Patent Document 1 uses a graphene film formed on a metal foil by CVD and transferred to a substrate, employing the transferred graphene as a gate. As for the two-dimensional semiconductor, it is formed on a metal foil by CVD and transferred to the desired substrate. This transistor shown in Non-Patent Document 1 has three major problems. The first problem is that the graphene or two-dimensional semiconductor transferred from the metal foil to the substrate is wrinkled and does not adhere completely to the three-dimensional structure of the substrate surface. Therefore, it exhibits device performance values lower than theoretical values and has low device reliability. The second problem is that the gate resistance is high. The high gate resistance is caused by using a single layer of graphene as the gate, which hinders the high-speed operation of the transistor. The third problem is that while existing device structures suitable for high-frequency applications have shortened or reduced certain structures or parts, such as gate electrodes and insulating layers, to tens of nanometers or even a few nanometers. However, device structures and layouts composed of two-dimensional materials or substances with layer thicknesses of one to several dozen atoms, as in this invention, have not been optimized. Due to these problems, the transistors with single-atom-length gates have not been practically implemented until now.

The present invention has been conceived in light of the above and the object of the present invention is to provide a transistor having an extremely short gate length (preferably at the single-atom level) and an extremely thin carrier transport layer (preferably at the single-atom level), and a highly reliable manufacturing method suitable for mass production thereof.

### MEANS FOR SOLVING THE PROBLEMS

The transistor according to an embodiment of the present invention comprises: a substrate that includes an uppermost plane, a vertical plane that intersects the uppermost plane and extends downwardly from the uppermost plane, and a lower plane substantially parallel to the uppermost plane and intersecting the vertical plane; a conductive thin film formed in contact with the uppermost plane of the substrate; an insulating film formed to cover at least the vertical plane and edges of the conductive thin film; a two-dimensional semiconductor layer formed to cover the uppermost plane, the vertical plane, and the lower plane, the two-dimensional semiconductor layer being also formed to cover the conductive thin film and/or insulating film at a portion where the conductive thin film and/or insulating film exist; a source electrode provided at a portion where the uppermost plane is covered by the two-dimensional semiconductor layer; and and a drain electrode provided at a portion where the lower plane is covered by the two-dimensional semiconductor layer. The uppermost plane and/or the lower plane may be flat surfaces.

In the present invention, the transistor may further include a shielding layer of a conductor on the conductive thin film, and insulating layers may be provided on both the front and back sides of the shielding layer.

In the present invention, the substrate may be a single crystal of silicon carbide (SiC) at least on its uppermost plane, and the conductive thin film may be graphene. Furthermore, the graphene, which is the conductive thin film, may be a single layer at the edge overlapping near the ridge where the uppermost plane intersects the vertical plane.

In the present invention, it is desirable that the substrate includes an inclined plane adjacent to the uppermost plane at an edge that is opposite to the edge contacting the vertical plane, and the inclined plane may be non-parallel to the uppermost plane. The conductive thin film may be formed from the uppermost plane across the inclined plane, and the conductive thin film on the inclined plane may be a multilayer graphene.

In the present invention, the substrate may be a single-crystal silicon carbide substrate or a hybrid substrate in which a single-crystal silicon carbide layer is formed on an insulator.

In the present invention, the two-dimensional semiconductor layer may be formed of a material selected from a group consisting of graphene, transition metal dichalcogenides, indium oxide, boron phosphide, and boron arsenide. It is particularly desirable for the two-dimensional semiconductor layer to be formed of transition metal dichalcogenide, which is one of molybdenum disulfide (MoS₂), tungsten disulfide (WS₂), and tungsten diselenide (WSe₂).

In the present invention, the insulating film may be formed of a material selected from a group consisting of hafnium oxide, silicon carbide, zirconium oxide, erbium oxide, aluminum oxide, and silicon carbide.

The integrated circuit according to an embodiment of the present invention comprises a plurality of transistors as described in claim 1 or 2. In the integrated circuit, the substrate may have two opposing vertical planes on the convex portion where the uppermost plane is formed, and two transistors may share one conductive thin film and one source electrode. Alternatively, the substrate may have two vertical planes that face each other on both sides of one lower plane, and two transistors may share one lower plane.

The method for manufacturing transistor according to an embodiment of the present invention comprises: a step of preparing a substrate; a step of forming a conductive thin film of 10 atomic layers or less on a flat uppermost plane of the substrate; a step of forming, by microfabrication, a vertical plane intersecting the uppermost plane and extending downward therefrom, and a lower plane substantially parallel to the uppermost plane and intersecting the vertical plane, while leaving part of the conductive thin film intact and removing the conductive thin film and the upper portion of the substrate from other parts; a step of depositing an insulating film to cover at least the vertical plane and an edge of the conductive thin film; a step of depositing a two-dimensional semiconductor layer so as to cover the uppermost plane, the vertical plane, and the lower plane, and so as to also cover the conductive thin film and/or insulating film at a portion where the conductive thin film and/or insulating film exist; and a step of forming a source electrode overlaid on a portion where the conductive thin film is covered by the two-dimensional semiconductor layer, and forming a drain electrode overlaid on a portion where the lower plane is covered by the two-dimensional semiconductor layer.

In the present invention, a step of providing a shielding layer overlaid on the conductive thin film may be further provided after forming the conductive thin film and before forming the vertical plane and the lower plane.

In the present invention, the substrate may be a single crystal of silicon carbide at least on an uppermost plane thereof, and in the step of forming the conductive thin film, graphene may be formed as the conductive thin film on the uppermost plane of the substrate. In the step of forming the conductive thin film, it is particularly desirable that the graphene, which is the conductive thin film, is formed such that the edge overlapping near the ridge where the uppermost plane and the vertical plane intersect is a single layer.

In the present invention, a step of forming an inclined plane adjacent to the uppermost plane and non-parallel to the uppermost plane may be provided, and in the step of forming the conductive thin film, the conductive thin film may be formed from the uppermost plane across the inclined plane, and the conductive thin film on the inclined plane is multilayer graphene.

In the present invention, the substrate may be a single-crystal silicon carbide substrate or a hybrid substrate in which a single-crystal silicon carbide layer is formed on an insulator.

In the present invention, the two-dimensional semiconductor layer may be formed of a material selected from a group consisting of graphene, transition metal dichalcogenides, indium oxide, boron phosphide, and boron arsenide. It is particularly desirable for the two-dimensional semiconductor layer to be formed of transition metal dichalcogenide, which is one of molybdenum disulfide (MoS₂), tungsten disulfide (WS₂), and tungsten diselenide (WSe₂).

In the present invention, the insulating film may be formed of a material selected from a group consisting of hafnium oxide, silicon carbide, zirconium oxide, erbium oxide, aluminum oxide, and silicon carbide.

### EFFECTS OF THE INVENTION

Transistors with extremely short gate lengths and extremely thin carrier transport layers suitable for high-frequency applications can be realized. In addition, such transistors can be manufactured with high reliability.

### BRIEF DESCRIPTION OF THE DRAWINGS

Fig. 1 is a cross-sectional view showing the basic structure of the transistor 1 according to the first embodiment of the present invention.
Fig. 2 is a cross-sectional view showing the structure of an integrated circuit in which a plurality of transistors 1 are formed on a single substrate.
Fig. 3 is a perspective view schematically showing the three-dimensional structure of the transistor 1 according to the first embodiment.
Fig. 4 is a plane view showing an exemplary layout for providing electrode pads on the transistor 1 according to the first embodiment.
Fig. 5 shows schematic diagrams of layouts for high output power using the transistor 1 according to the first embodiment.
Fig. 6 is a diagram showing an example of the procedure for manufacturing the transistor 1 according to the first embodiment.
Fig. 7 is a cross-sectional view showing the basic structure of the transistor 1a according to the second embodiment of the present invention.

### EMBODIMENTS OF THE INVENTION

Hereinafter, embodiments of the present invention will be described. Common components in each drawing, including the drawings used to explain the background technology, are indicated by the same reference sign.

### [First Embodiment]

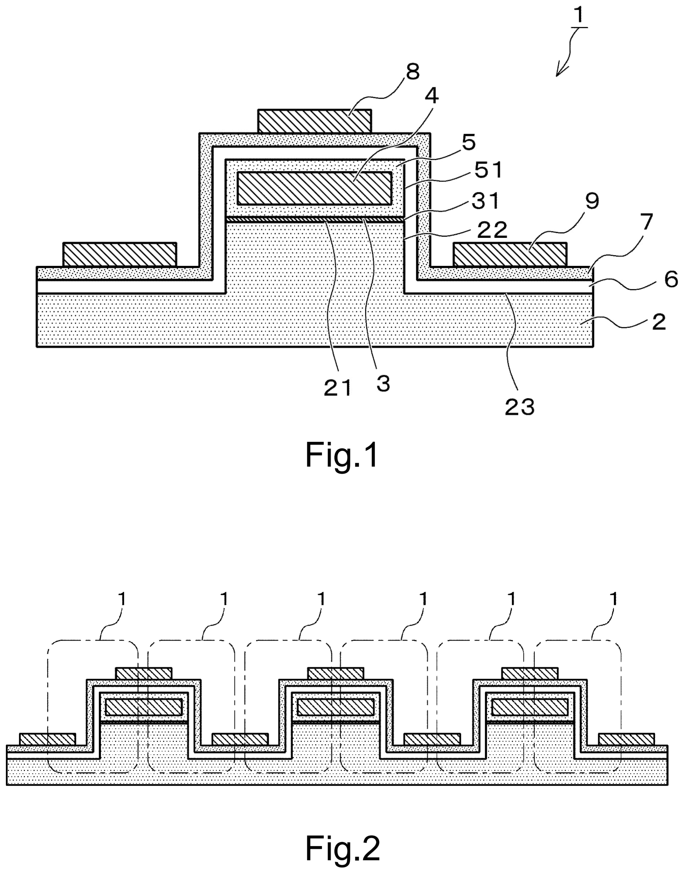

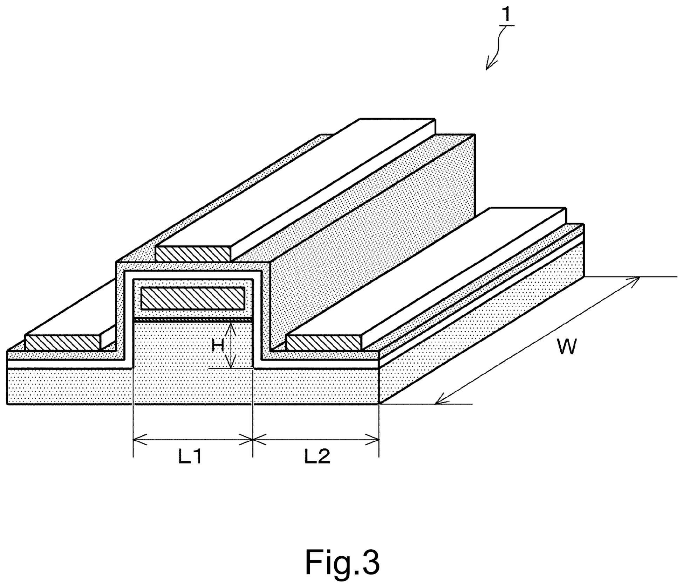

Fig. 1 is a cross-sectional view showing the basic structure of the transistor 1 according to the first embodiment of the present invention. Fig. 2 is a cross-sectional view showing the structure of an integrated circuit in which a plurality of transistors 1 are formed on a single substrate. Fig. 3 is a perspective view schematically showing the three-dimensional structure of the transistor 1 according to the first embodiment. As shown in Fig. 1, the transistor 1 comprises a substrate 2, a conductive thin film 3, a shielding layer 4, an insulating layer 5, an insulating film 6, a two-dimensional semiconductor layer 7, an electrode 8, and an electrode 9.

The substrate 2 is the basis for forming a structure of the transistor 1. The substrate 2 is preferably a high-resistance substrate with a resistance of at least 10,000 Ω on at least the surface thereof. As the substrate 2, it is preferable to use a material containing silicon carbide, and it is preferable to use one where at least an uppermost plane 21 is a silicon carbide single-crystal. More specifically, the substrate 2 may be a single-crystal substrate of silicon carbide or a hybrid substrate with a single-crystal layer of silicon carbide fabricated on an insulator (e.g.,single-crystal Si, sapphire, etc.). With a substrate where the uppermost plane 21 is a single-crystal silicon carbide, a graphene thin film (preferably a single atomic layer) can be formed as the conductive thin film 3 on the uppermost plane 21. When adopting materials other than graphene as the conductive thin film 3, the substrate 2 may be made of silicon (Si), sapphire, quartz glass substrate, flexible substrates composed of film-like resins such as polyimide or PET (Polyethylene terephthalate), or transparent conductive oxides such as ITO (Indium Tin Oxide) or FTO (Fluorine-doped Tin Oxide).

The substrate 2, as shown in Fig. 1, has the uppermost plane 21, a vertical plane 22, and a lower plane 23 formed on one of the surfaces thereof. The uppermost plane 21 is the uppermost flat surface on the substrate 2. The vertical plane 22 is a plane that intersects the uppermost plane 21 and extends downwardly from the uppermost plane 21. In the example in Fig. 1, the vertical plane 22 and the uppermost plane 21 are perpendicular to each other. The lower plane 23 intersects the vertical plane 22 and is formed as a plane substantially parallel to the uppermost plane 21. In the example of Fig. 1, the lower plane 23 is perpendicular to the vertical plane 22, and the uppermost plane 21 and the lower plane 23 are parallel When the vertical plane 22 is to be a crystalline layer, its surface may be a (0001) plane. The length from one end to the other end of the uppermost plane 21 (L1 in Fig. 3), and the length from one end to the other end on the lower plane 23 (L2 in Fig. 3), may each be set to 100 nm to 5 µm. Furthermore, the height of the vertical plane (H in Fig. 3) may be 30 to 100 nm.

The conductive thin film 3 is an extremely thin conductor film of a single atomic layer or several atomic layers (10 atomic layers or less) formed in contact with the uppermost plane 21 of the substrate 2. The thickness of the conductive thin film 3 is about several nm (preferably 5 nm) or less. Furthermore, the length of the conductive thin film 3 from one end to the other end may be 100 nm to 5 µm, matching the length L1 of the uppermost plane 21 of the substrate 2. Layered conductor materials are suitable as the conductive thin film 3. Specifically, graphene, borophene, which is a two-dimensional crystal of boron, or derivatives of borophene may be used. Graphene is particularly suitable as the conductive thin film 3 because it is possible to be formed as a single-layer thin film on the (0001) plane of silicon carbide, which is suitable as the substrate 2. Otherwise, titanium nitride (TiN) may be used as the conductive thin film 3. The conductive thin film 3 is provided to cover the entire uppermost plane 21 up to the vicinity of the ridge where the uppermost plane 21 and the vertical plane 22 intersect on the substrate 2. The edge 31 of the conductive thin film 3, which overlaps the vicinity of the ridge where the uppermost plane 21 intersects with the vertical plane 22, functions as the gate in the transistor 1. Moreover, portions of the conductive thin film 3 other than the aforementioned edge 31 function as wiring from the gate electrode pad 10 to the gate, as described later.

The shielding layer 4 is a layer of a conductor such as metal provided on the conductive thin film 3, shielding the space between the electrode 8 and the conductive thin film 3. The shielding layer 4 is electrically connected to a predetermined ground potential (e.g., 0 V). The insulating layer 5 is provided on at least both the front and back surfaces of the shielding layer 4 to prevent the shielding layer 4 from short-circuiting with the conductive thin film 3 or the electrode 8. Aluminum (Al) or nickel (Ni) is preferred as the shielding layer 4. When Al is used as the shielding layer 4, the natural oxide film formed on the surface of Al can be used as the insulating layer 5 as it is, simplifying the manufacturing process. When using Ni as the shielding layer 4, it is necessary to form the separate insulating layer 5 to prevent short circuits with the conductive thin film 3 or the electrode 8. When there is no need to shield the space between the electrode 8 and the conductive thin film 3 (for example, when signal interference between the electrode 8 and the conductive thin film 3 is not a problem), the transistor 1 does not need to have the shielding layer 4 and the insulating layer 5. The end plane 51 of the insulating layer 5 may be a plane that is roughly coincident with the vertical plane 22.

The insulating film 6 is a thin film of insulator that serves as the gate insulating film of the transistor 1. As insulating film 6, a high dielectric constant insulating film such as hafnium oxide, silicon carbide, zirconium oxide, erbium oxide, aluminum oxide, or a thin film of silicon carbide can be used. For high-frequency applications exceeding 1 THz, a thin film of silicon carbid is suitable. In the example shown in Fig. 1, the insulating film 6 is formed to cover the top surface of the insulating layer 5, extending down through the end plane 51, edge 31, and vertical plane 22 to the lower plane 23. If the insulating film 6 covers at least the vertical plane 22, the edge 31, and the end plane 51 of the substrate 2, it may be unnecessary to form the insulating film 6 for other portions of the substrate 2. For example, in a configuration with the insulating layer 5 and the shielding layer 4, there is no need to provide the insulating film 6 on the insulating layer 5. On the other hand, in a configuration without the insulating layer 5 and the shielding layer 4, the insulating film 6 must be provided between the conductive thin film 3 and the electrode 8 as well to prevent a short circuit between the conductive thin film 3 and the electrode 8. If the substrate 2 has sufficient insulating properties, it is not necessary to provide insulating film 6 on the lower plane 23.

The two-dimensional semiconductor layer 7 is a layer of semiconductors that serves as the carrier transport layer of the transistor 1. The two-dimensional semiconductor layer 7 is formed to cover the uppermost plane 21, the vertical plane 22, and the lower plane 23. For portions where there is the conductive thin film 3, the shielding layer 4, the insulating layer 5, and/or the insulating film 6, the two-dimensional semiconductor layer 7 is formed overlaid to cover these as well. For the two-dimensional semiconductor layer 7, mono or multi-atomic layers of graphene, transition metal dichalcogenide (e.g., molybdenum disulfide (MoS₂), tungsten disulfide (WS₂), tungsten diselenide (WSe₂)), indium oxide (In₂O₃), boron phosphide, boron arsenide, and the like can be used. For high-frequency applications such as those above 1 THz, graphene is suitable as the two-dimensional semiconductor layer 7. For high-frequency applications between 300 GHz and 1 THz, transition metal dichalcogenides such as MoS₂ and WS₂ are suitable as the two-dimensional semiconductor layer 7. For relatively low frequency applications such as logic circuits, In₂O₃ and transition metal dichalcogenides are suitable as the two-dimensional semiconductor layer 7.

The electrodes 8 and 9 are made of metals such as Au, Al, In, Bi, Ni, Pd, Ti, and Pt, or transparent conductive oxides such as ITO or FTO. The electrode 8 is overlaid on a portion of the two-dimensional semiconductor layer 7 where it covers the conductive thin film 3, and functions as the source electrode of the transistor 1. The electrode 9 is overlaid on a portion of the two-dimensional semiconductor layer 7 where it covers the lower plane 23, and functions as the drain electrode of the transistor 1.

In the transistor 1 having the basic structure described above, the plane on which the conductive thin film 3 is formed and the two-dimensional semiconductor layer 7 covering the vertical plane 22 are orthogonal to each other, and the edge 31 of the conductive thin film 3 faces the two-dimensional semiconductor layer 7 across the insulating film 6, so the thickness of the conductive thin film 3 defines the gate length of the transistor 1. If the conductive thin film 3 is a monatomic layer of graphene, the gate length of the transistor 1 can be reduced to 0.3 nm. Even when a conductive thin film 3 is adopted other than a single atomic layer of graphene, a gate length of several nm or less corresponding to the thickness of the conductive thin film 3 can be achieved.

Fig. 2 is a cross-sectional view showing the structure of an integrated circuit in which a plurality of transistors 1 are formed on a single substrate. The structure of transistor 1 described above, which includes the electrode 8 on the uppermost plane 21 and the electrode 9 on the lower plane 23, with the edge 31 of the conductive thin film 3 serving as the gate, can be formed on both sides of the convex portion of substrate 2, as shown in Fig. 2, where the uppermost plane 21 is formed in a manner sharing the conductive film 3 and the electrode 8. Alternatively, the transistor 1 may be formed on both the left and right sides of the lower plane 23 in a manner sharing the electrode 9. In this manner, an integrated circuit with a plurality of transistors 1 formed on substrate 2 can be provided. As shown in Fig. 2, by repeatedly forming the same structure as in Fig. 1, it is possible to create a larger-scale integrated circuit that integrates a greater number of transistors 1 (six in the example of Fig. 2).

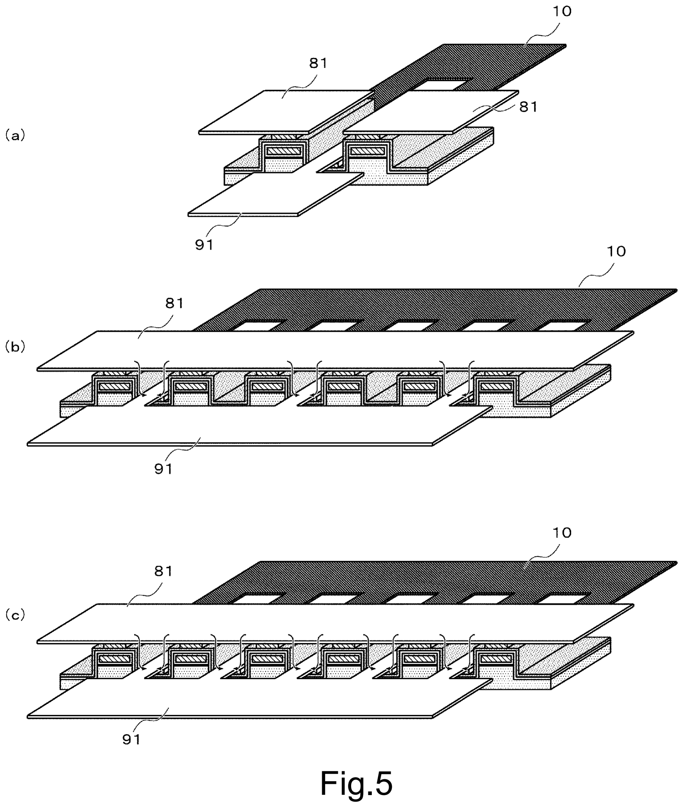

Fig. 3 is a perspective view schematically showing the three-dimensional structure of the transistor 1 according to the first embodiment. The cross-sectional structure of the transistor 1 shown in Fig. 1 is formed across the required width W, as shown in Fig. 3. The width W can be determined arbitrarily depending on factors such as the amount of the current flowing in the transistor 1; however, from the standpoint of reliability, it is preferable to set the width W to approximately 30 to 50 µm. For example, if the allowable current per unit width of the channel is set to 1 A/mm and the width W is set to 50 µm, a current of 50 mA can flow through the structure of a single transistor 1. To flow a greater current, it is advantageous to adopt a structure such as that shown in Fig. 2 or a layout such as that described later and shown in Fig. 5 to substantially expand the channel width by using a plurality of transistor 1 structures in parallel, thereby achieving the required allowable current.

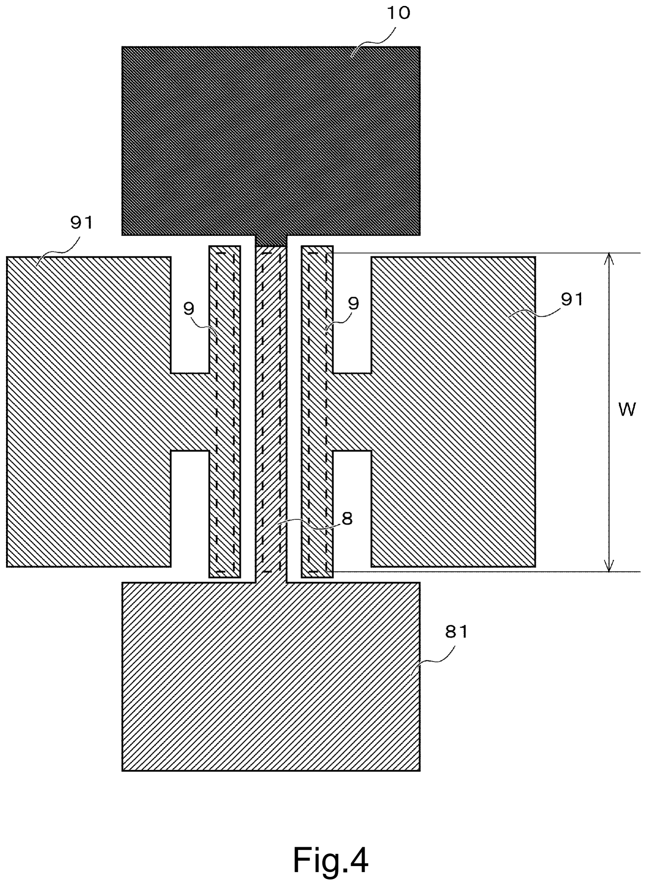

As shown in Fig. 4, the transistor 1 is provided with a plurality of electrode pads for connection to external components. A source electrode pad 81 is provided overlaying the electrode 8 and is electrically connected to the electrode 8. A drain electrode pad 91 is provided overlaying the electrode 9 and is electrically connected to the electrode 9. Furthermore, a gate electrode pad 10 is provided outside the width W and is electrically connected to the conductive thin film 3. The source electrode pad 81, the drain electrode pad 91, and the gate electrode pad 10 are each formed with an area sufficient to enable wire bonding or bump formation, facilitating connection between the source, drain, and gate of the transistor 1 and the external components. Although not depicted in Fig. 4, an additional electrode pad may be provided to connect the shielding layer 4 to an external ground potential. The structure shown in Fig. 4 may be formed in an area of about 100 µm square, for example.

(a)-(c) in Fig. 5 are schematic diagrams of layout for high output power using the transistor 1 according to the first embodiment. (a) in Fig. 5 is a schematic diagram of a layout that enhances output power by placing the structure shown in Fig. 1 on both sides of a common drain electrode 9. Compared to conventional devices, it enables two devices to be placed and connected closer together, reducing transmission loss and parasitic resistance in the connecting wiring circuit. This suppresses power loss at high frequencies and enables higher output. (b) and (c) in Fig. 5 show configurations where even more transistors 1 are arranged to achieve further high output. The allowable current increases proportionally to the number of transistors arranged, enabling high output. Furthermore, by changing the number and arrangement of the comb-shaped electrodes extending from the drain electrode pad 91 onto the electrodes 9, the number of transistors 1 that work and form the current path (channel layer) can be arbitrarily determined. Comparing the configuration of (b) in Fig. 5, where comb-shaped electrodes are thinned out, with the configuration of (c) in Fig. 5, where comb-shaped electrodes are provided on all electrodes 9, the configuration of (c) in Fig. 5 forms twice as many current paths (channel layers), resulting in twice the current value and mutual conductance (gm), enabling higher output. Note that for the portions where comb-shaped electrodes are thinned out in (b) in Fig. 5, it is not necessary to provide electrodes 9.

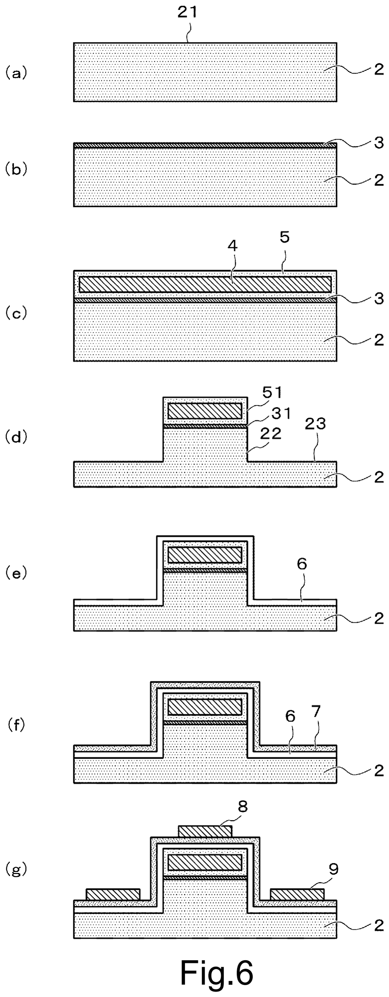

Next, referring to Fig. 6, a method for manufacturing a transistor 1 with a structure comprising a single layer graphene on a silicon carbide substrate, as an example of the transistor 1 according to the present embodiment, will be described.

First, as the substrate 2, a substrate with a top surface being the (0001) plane of silicon carbide is prepared ((a) in Fig. 6). Then, a single-layer graphene layer, which becomes the conductive thin film 3, is formed on the top surface of substrate 2 ((b) in Fig. 6). The graphene layer can be formed using methods such as thermal sublimation of Si atoms, chemical vapor deposition, or molecular beam epitaxy. Then, the shielding layer 4 of Al is formed on the conductive thin film 3. During the formation and microfabrication of the shielding layer 4, the insulating layer 5 of natural oxide film is formed to cover the surface of the shielding layer 4 ((c) in Fig. 6). When using materials other than aluminum that do not form a natural oxide film as the shielding layer 4, it is advisable to form insulating layers above and below the shielding layer 4 to ensure electrical insulation between the shielding layer 4 and the conductive thin film 3 or electrode 8.

Then, by performing microfabrication using reactive ion etching or neutral beam etching with chlorine or fluorine gas, the vertical plane 22 and the lower plane 23 are formed on the substrate 2 by digging down a portion of substrate 2, the vertical plane 22 and the lower plane 23 are formed on substrate 2, and the shielding layer 4 is processed to align with the vertical plane 22 (Fig. (d) in Figure 6). During the microfabrication process, the side surface of the shielding layer 4 is exposed, but a new natural oxide film insulating layer 5 is formed to cover the exposed surface. The vertical plane 22 and lower plane 23 formed by the microfabrication process lack a graphene layer, but the conductive thin film 3 of single-layer graphene remains on the uppermost plane 21 that is left intact. Subsequently, the insulating film 6 is deposited ((e) in Fig. 6). In the example shown in (e) in Fig. 6, the insulating film 6 is formed to cover the top surface of the insulating layer 5, extending down through the end plane 51, edge 31, and vertical plane 22 to the lower plane 23. If the insulating film 6 covers at least the vertical plane 22, the edge 31, and the end plane 51 of the substrate 2, it may be unnecessary to form the insulating film 6 for other portions of the substrate 2. Subsequently, the two-dimensional semiconductor layer 7 is deposited to cover the uppermost plane 21, the vertical plane 22, and the lower plane 23 ((f) in Fig. 6). At this time, for portions where there is the conductive thin film 3, the shielding layer 4, the insulating layer 5, and/or the insulating film 6, the two-dimensional semiconductor layer 7 is formed overlaid to cover these as well. Then, the electrode 8 is formed overlaid on the portion where the conductive thin film 3 is covered by the two-dimensional semiconductor layer 7, and the electrode 9 is formed overlaid on the portion where the lower plane 23 is covered by the two-dimensional semiconductor layer 7 ((g) in Fig. 6). Accordingly, the basic structure of the transistor 1 is completed. By providing the source electrode pad 81, the drain electrode pad 91, and the gate electrode pad 10 on the electrode 8, the electrode 9, and the conductive thin film 3, respectively, a device capable of external connection is obtained.

The transistor 1 described above enables single-atom-length gate lengths (approximately 0.3 nm), making it possible to achieve higher speeds than the currently fastest high-electron-mobility transistors (InGaAs-HEMTs) with InGaAs compound semiconductor channels. Furthermore, even with the conductive thin film being several atomic layers thick (e.g., approximately 1 nm), it enables shorter gate lengths and higher speeds compared to current transistors approaching the limits of exposure equipment.

Since the conductive thin film 3 and the two-dimensional semiconductor layer 7 are grown directly on the uppermost plane 21 or the insulating film 6, rather than being transferred from another substrate, they do not wrinkle and can be made to adhere completely to the three-dimensional structure of the substrate surface.

Furthermore, the transistor 1 according to the present embodiment can utilize the two-dimensional semiconductor with a bandgap approximately three times larger than InGaAs in the two-dimensional semiconductor layer 7, thereby enabling high output performance exceeding InGaAs-HEMT by more than an order of magnitude.

Furthermore, in the transistor 1 of the present embodiment, Si with silicon carbide thin film, silicon carbide, sapphire with silicon carbide thin film, etc., can be used as the substrate 2, allowing for a high degree of freedom in substrate selection. Thus, it is possible to expand applications not only to ultrahigh-frequency devices but also to large-scale logic integrated circuits.

### [Second Embodiment]

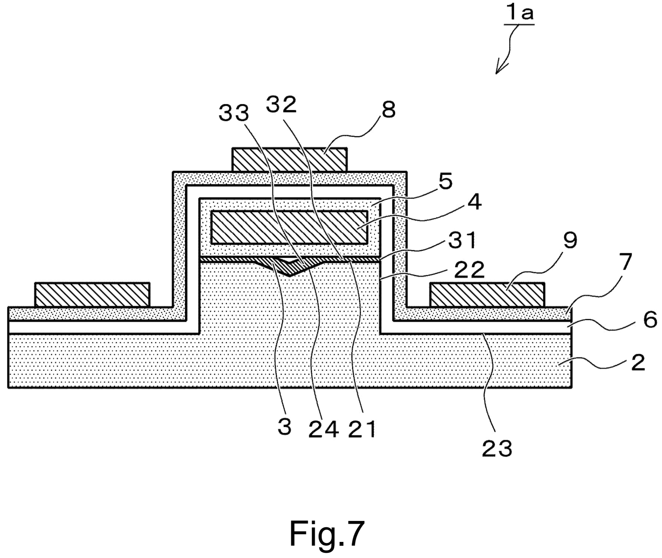

Next, referring to Fig. 7, the transistor 1a according to the second embodiment of the present invention will be described. High gate resistance suppresses the high-frequency characteristics of the transistor. In the transistor 1 of the first embodiment structure, when a single-layer graphene is used for the conductive thin film 3, its extremely thin thickness results in high gate resistance. In the transistor 1a of the present embodiment, the gate resistance is suppressed by using the edge of the single-layer graphene as the gate electrode while multilayering the graphene in areas other than the vicinity of the edge. The feature of the present embodiment is the configuration for multilayering the graphene in areas other than the vicinity of the edge in the first embodiment. Since the other aspects are the same as the first embodiment described above, the explanation here is omitted.

Fig. 7 is a cross-sectional view showing the basic structure of the transistor 1a according to the second embodiment. The transistor 1a, similar to the transistor 1 of the first embodiment, comprises a substrate 2, a conductive thin film 3, a shielding layer 4, an insulating layer 5, an insulating film 6, a two-dimensional semiconductor layer 7, an electrode 8, and an electrode 9. The substrate 2 used for the transistor 1a has an inclined plane 24 in addition to the uppermost plane 21, the vertical plane 22, and the lower plane 23. In the substrate 2, at least the uppermost plane 21 and the inclined plane 24 are made of single-crystal silicon carbide. The uppermost plane 21 may be considered the (0001) plane of silicon carbide. The inclined plane 24 is a non-parallel (inclined) plane adjacent to the uppermost plane 21, provided at the end opposite the edge contacting the vertical plane 22 of the uppermost plane 21. The inclination angle of the inclined plane 24 may be arbitrary, but may be set to, for example, 45°, 22°, etc. The inclined plane 24 with such an inclination angle can be formed, for example, in reactive ion etching using Cl₂, by appropriately adjusting the gas flow rate and radio frequency power (for example, to a gas flow rate of 40 sccm and radio frequency power of 50 W). Furthermore, the inclination angle of the inclined plane 24 need not be constant; it may, for example, be formed as a curved surface. Such an inclined plane 24 is provided prior to the formation of the conductive thin film 3. In the present embodiment, the conductive thin film 3 is simultaneously formed from the uppermost plane 21 across the inclined plane 24. Because the growth rate of graphene on the inclined plane 24 is faster than the growth rate of graphene on the uppermost plane 21, the (0001) plane of silicon carbide, multiple layers (preferably 10-20 layers) of graphene are grown on inclined plane 24 while a single layer of graphene is grown on the uppermost plane 21. Therefore, the conductive thin film 3 in the present embodiment is formed from the uppermost plane 21 across the inclined plane 24, with single-layer graphene 32 near the edge 31 and transitioning to multilayer graphene 33 on the inclined plane 24 in the inner region. The distance from the ridge where the uppermost plane 21 intersects the vertical plane 22 to the inclined plane 24 (i.e., the length of the uppermost plane 21) may be a sufficient distance to prevent the formation of multilayer graphene from extending near the edge 31 (e.g., several hundred nm).

The transistor 1a is formed by providing the shielding layer 4, the insulating layer 5, the insulating film 6, the two-dimensional semiconductor layer 7, the electrode 8, and the electrode 9, similar to those in the first embodiment, on the conductive thin film 3 described above. Note that although the inclination of the underlying inclined plane 24 may result in a depression in the conductive thin film 3, it is preferable to fill this depression with insulating material or the like before stacking the shielding layer 4, the insulating film 6, and the two-dimensional semiconductor layer 7, thereby ensuring a flat surface.

In the transistor 1a configured as described above, in addition to the same effects as the transistor 1 of the first embodiment, the conductive thin film 3 as a whole can be made low-resistance because the carrier density increases due to the multilayer graphene forming the conductive thin film 3. On the other hand, at the edge 31 of the conductive thin film 3, the single-layer graphene functions as a gate electrode by facing the two-dimensional semiconductor layer 7 across the insulating film 6. This allows the gate length of the transistor 1 to be reduced to the thickness of a single atom (approximately 0.3 nm).

The above describes the present embodiment and its specific examples, but the invention is not limited to these examples. Any addition, deletion, or design modification of components made by a person skilled in the art to the aforementioned embodiments or their specific examples, or any appropriate combination of the features of each embodiment, is also included within the scope of the invention as long as it has the essentials of the invention.

### REFERENCE SIGNS LIST

- 1, 1a: Transistor
- 2: Substrate
- 21: Uppermost plane
- 22: Vertical plane
- 23: Lower plane
- 24: Inclined plane
- 3: Conductive thin film
- 31: Edge
- 32: Single-layer graphene
- 33: Multilayer Graphene
- 4: Shielding layer
- 5: Insulating layer
- 51: End plane
- 6: Insulating film
- 7: Two-dimensional semiconductor layer
- 8, 9: Electrode
- 81: Source electrode pad
- 91: Drain electrode pad
- 10: Gate electrode pad

## Claims

1. A transistor comprising:
a substrate that includes an uppermost plane, a vertical plane intersecting the uppermost plane and extending downwardly therefrom, and a lower plane substantially parallel to the uppermost plane and intersecting the vertical plane;
a conductive thin film formed in contact with the uppermost plane of the substrate;
an insulating film formed to cover at least the vertical plane and edges of the conductive thin film;
a two-dimensional semiconductor layer formed to cover the uppermost plane, the vertical plane, and the lower plane, the two-dimensional semiconductor layer being also formed to cover the conductive thin film and/or insulating film at a portion where the conductive thin film and/or insulating film exists;
a source electrode provided at a portion where the uppermost plane is covered by the two-dimensional semiconductor layer; and
a drain electrode provided at a portion where the lower plane is covered by the two-dimensional semiconductor layer.

2. The transistor according to claim 1, further comprises:
a shielding layer of a conductor on the conductive thin film; and
insulating layers provided on both the front and back sides of the shielding layer.

3. The transistor according to claim 1 or 2, wherein the substrate is a single crystal of silicon carbide at least on an uppermost plane thereof, and
the conductive thin film is graphene.

4. The transistor according to claim 3, wherein the graphene, which is the conductive thin film, is a single layer at the edge overlapping near the ridge where the uppermost plane intersects the vertical plane.

5. The transistor according to claim 4, wherein the substrate includes an inclined plane adjacent to the uppermost plane at the edge that is opposite to the edge contacting the vertical plane, and the inclined plane being non-parallel to the uppermost plane,
the conductive thin film is formed extending from the uppermost plane across the inclined plane, and
the conductive thin film on the inclined plane is multilayer graphene.

6. The transistor according to claim 1 or 2, wherein the substrate is a silicon carbide single crystal or a hybrid substrate in which a single-crystal silicon carbide layer is fabricated on an insulator.

7. The transistor according to claim 1 or 2, wherein the two-dimensional semiconductor layer is formed of a material selected from a group consisting of graphene, transition metal dichalcogenides, indium oxide, boron phosphide, and boron arsenide.

8. The transistor according to claim 7, wherein the two-dimensional semiconductor layer is formed of transition metal dichalcogenides, which are one of molybdenum disulfide (MoS₂), tungsten disulfide (WS₂), and tungsten diselenide (WSe₂).

9. The transistor according to claim 1 or 2, wherein the insulating film is formed of a material selected from a group consisting of hafnium oxide, silicon carbide, zirconium oxide, erbium oxide, aluminum oxide, and silicon carbide.

10. An integrated circuit comprising a plurality of transistors as described in claim 1 or 2, wherein the substrate has two opposing vertical planes on the convex portion where the uppermost plane is formed, and
two transistors share one conductive thin film and one source electrode.

11. An integrated circuit comprising a plurality of transistors as claimed in claim 1 or 2, wherein the substrate has two vertical planes that face each other on both sides of one lower plane, and
the two transistors share said one lower plane.

12. A method for manufacturing transistor comprising:
a step of preparing a substrate;
a step of forming a conductive thin film of 10 atomic layers or less on a flat uppermost plane of the substrate;
a step of forming, by microfabrication, a vertical plane intersecting the uppermost plane and extending downward therefrom, and a lower plane substantially parallel to the uppermost plane and intersecting the vertical plane, while leaving part of the conductive thin film intact and removing the conductive thin film and the upper portion of the substrate from other parts;
a step of depositing an insulating film to cover at least the vertical plane and an edge of the conductive thin film;
a step of depositing a two-dimensional semiconductor layer so as to cover the uppermost plane, the vertical plane, and the lower plane, and so as to also cover the conductive thin film and/or insulating film where the conductive thin film and/or insulating film exist; and
a step of forming a source electrode overlaid on a portion where the conductive thin film is covered by the two-dimensional semiconductor layer, and forming a drain electrode overlaid on a portion where the lower plane is covered by the two-dimensional semiconductor layer.

13. The method for manufacturing according to claim 12, further comprising a step of providing a shielding layer overlaid on the conductive thin film after forming the conductive thin film and before forming the vertical plane and the lower plane.

14. The method for manufacturing according to claim 12 or 13, wherein the substrate is a single crystal of silicon carbide at least on an uppermost plane thereof, and
in the step of forming the conductive thin film, graphene is formed as the conductive thin film on the uppermost plane of the substrate.

15. The method for manufacturing according to claim 12 or 13, wherein, in the step of forming the conductive thin film, the graphene, which is the conductive thin film, is formed such that the edge overlapping near the ridge where the uppermost plane and the vertical plane intersect is a single layer.

16. The method for manufacturing according to claim 15, comprising a step of forming an inclined plane adjacent to the uppermost plane and non-parallel to the uppermost plane prior to the step of forming the conductive thin film, and
wherein, in the step of forming the conductive thin film, the conductive thin film is formed from the uppermost plane across the inclined plane, and the conductive thin film on the inclined plane is multilayer graphene.

17. The method for manufacturing according to claim 12 or 13, wherein the substrate is a silicon carbide single crystal or a hybrid substrate in which a single-crystal silicon carbide layer is fabricated on an insulator.

18. The method for manufacturing according to claim 12 or 13, wherein the two-dimensional semiconductor layer is formed of a material selected from a group consisting of graphene, transition metal dichalcogenides, indium oxide, boron phosphide, and boron arsenide.

19. The method for manufacturing according to claim 18, wherein the two-dimensional semiconductor layer is formed of transition metal dichalcogenides, which are one of molybdenum disulfide (MoS₂), tungsten disulfide (WS₂), and tungsten diselenide (WSe₂).

20. The method for manufacturing according to claim 12 or 13, wherein the insulating film is formed of a material selected from a group consisting of hafnium oxide, silicon carbide, zirconium oxide, erbium oxide, aluminum oxide, and silicon carbide.
